# EUROPÄISCHE PATENTSCHRIFT

(11) **EP 0 936 740 B1**
(45) Veröffentlichungstag und Bekanntmachung des Hinweises auf die Patenterteilung: **14.06.2006**
(21) Anmeldenummer: 99810021.8
(22) Anmeldetag: 14.01.1999
(51) Int. Cl.: H03K 17/95

(54) **Induktiver Näherungsschalter**
Inductive proximity switch
Commutateur de proximité inductif

(30) Priorität: 17.02.1998 EP 98810127
(43) Veröffentlichungstag der Anmeldung: 18.08.1999
(73) Patentinhaber: Optosys SA, 1762 Givisiez (CH)
(72) Erfinder: Heimlicher, Peter, 1700 Freiburg (CH)
(74) Vertreter: AMMANN PATENTANWÄLTE AG BERN

(56) Entgegenhaltungen:
- EP-A- 0 492 029
- US-A- 4 544 892

## Beschreibung

Die Erfindung betrifft einen induktiven Näherungsschalter gemäss dem Oberbegriff des Patentanspruchs 1.

Das Prinzip eines Näherungsschalters der oben erwähnten Art ist aus der EP-A-0492029 B1 bekannt. Bei diesem Näherungsschalter werden periodische unipolare Spannungsimpulse mit einer Periode T an die Spule 11 gelegt. Als Nutzsignal wird mit einer geeigneten Schaltung die Spannung erfasst, die nach dem Ende eines Sendestromimpulses durch den in dem zu erfassenden Körper, der aus einem elektrisch leitfähigen Material besteht, fliessenden abklingenden Strom, der dort vorher infolge der durch die vom Sendestromimpuls induzierten Spannung fliesst, in der Spule 11 induziert wird.

Der aus der EP-A-0492029 B1 bekannte Näherungsschalter hat folgende Nachteile:
- Störende eingestreute niederfrequente Magnetfelder überlagern dem Nutzsignal ein Störsignal, dessen Amplitude sehr erheblich sein kann und beeinträchtigen damit das Schaltverhalten des Näherungsschalters.
- Da das Nutzsignal mit einem erheblichen Störsignalanteil behaftet sein kann, ist es zweckmässig, es nur über ein relativ kurzes Zeitfenster zu integrieren, damit das Störsignal jeweils gegen Ende einer Periode T mit einem zweiten kurzen Zeitfenster erfasst werden kann. Das resultierende Nutzsignal ist daher relativ schwach. Die Wahl der geeigneten Lage und Dauer der soeben erwähnten Zeitfenster ist nicht einfach und bedingt einen Kompromiss zu Lasten der Leistungsfähigkeit des Sensors.
- Aus den oben genannten Gründen steht das Nutzsignal nur während eines relativen kleinen Teils seiner Gesamtdauer zur weiteren Verarbeitung zur Verfügung, was die Leistungsfähigkeit des Sensors weiter beeinträchtigt.
- Der unipolare Charakter der Sendeimpulse bedingt, dass bei jeder Periode T mit dem nächsten Sendeimpuls solange zugewartet werden muss, bis der von der in dem zu erfassenden Körper induzierte Spannung verursachte Strom fast vollständig abgeklungen ist. Andernfalls kommt es zu einer Kumulation von Strömen im zu erfassenden Körper, wodurch die Qualität des Empfangssignals beeinträchtigt wird. Die genannte Wartezeit bedingt eine niedrige Taktfrequenz, wodurch die maximale Schaltfrequenz des Gerätes reduziert wird (gemäss der einschlägigen Produktenorm EN 60947-5-2, Art. 2.4.3 ist die Schaltfrequenz gleich der Anzahl der Schaltspiele eines Näherungsschalters in einem festgelegten Zeitintervall).
- Schaltungsmässig erfordert die Beseitigung von Verstärkeroffsetspannungen infolge der Gleichspannungskomponente im Empfangssignal einen Mehraufwand.

Der Erfindung liegt die Aufgabe zugrunde, einen induktiven Näherungsschalter der eingangs erwähnten Art zu konzipieren, mit dem die oben erwähnten Nachteile beseitigt werden.

Erfindungsgemäss wird diese Aufgabe mit einem induktiven Näherungsschalter der eingangs erwähnten Art gelöst, der durch die im kennzeichnenden Teil des Patentanspruchs 1 definierten Merkmale gekennzeichnet ist.

Mit einem erfindungsgemässen induktiven Näherungsschalter werden insbesondere folgende Vorteile erzielt:
- Die störende Wirkung von eingestreuten niederfrequenten Magnetfeldern lässt sich fast vollständig eliminieren. Der Störabstand des Nutzsignals und damit die Zuverlässigkeit des Schaltverhaltens des Näherungsschalters werden daher erheblich erhöht.
- Das Nutzsignal wird durch nur ein Zeitfenster erfasst, das zudem den überwiegenden Teil von dessen Dauer umfasst. Dadurch steigt die Qualität des zur Weiterverarbeitung zur Verfügung stehenden Signals.
- Da das fast vollständige Abklingen eines Nutzsignals nicht abgewartet werden muss, bevor der nächste Sendestromimpuls gestartet wird, kann die Taktfrequenz und damit die nutzbare Schaltfrequenz des Näherungsschalters erhöht werden.
- Die Polarität der Sendestromimpulse wechselt bei jedem Impuls. Dadurch kann sich auch bei kurzer Periode T keine störende Stromakkumulation im zu erfassenden Körper einstellen.
- Bei der Ermittlung der geeigneten Lage und Dauer des oben erwähnten Zeitfensters muss kein Kompromiss eingegangen werden. Ein Zeitfenster, das eine optimale Abstimmung des Schaltabstandes für verschiedene Metalle ermöglicht, z.B. Stahl und Aluminium, kann frei gewählt werden.
- Die soeben erwähnten verbesserten Eigenschaften des Nutzsignals ermöglichen eine erhebliche Erhöhung des Schaltabstandes.
- Der Schaltungsaufwand im Verstärkerteil ist kleiner, weil durch die Verwendung von Wechselspannungskopplung und einer geeigneten Verarbeitung des Nutzsignals ein Mehraufwand zur Beseitigung von Verstärkeroffsetspannungen nicht erforderlich ist.

Ein Ausführungsbeispiel der Erfindung wird im folgenden anhand der beiliegenden Figuren 1 bis 4 erläutert.
- Figur 1: zeigt ein Blockschaltbild der elektronischen Schaltung eines erfindungsgemässen Näherungsschalters,
- Figur 2: zeigt Diagramme von Signalen, die zu einem Ausführungsbeispiel der Signale zum Betrieb der Schaltung gemäss Fig. 1 gehören,
- Figur 3: zeigt im Detail den Aufbau der Brückenschaltung 14 in Fig. 1 und Teile des Impulsgenerators 15 und des Eingangsverstärkers 17,
- Figur 4: zeigt einen schematischen Querschnitt eines Näherungsschalters, in dem die Schaltung gemäss Fig. 1 enthalten ist.

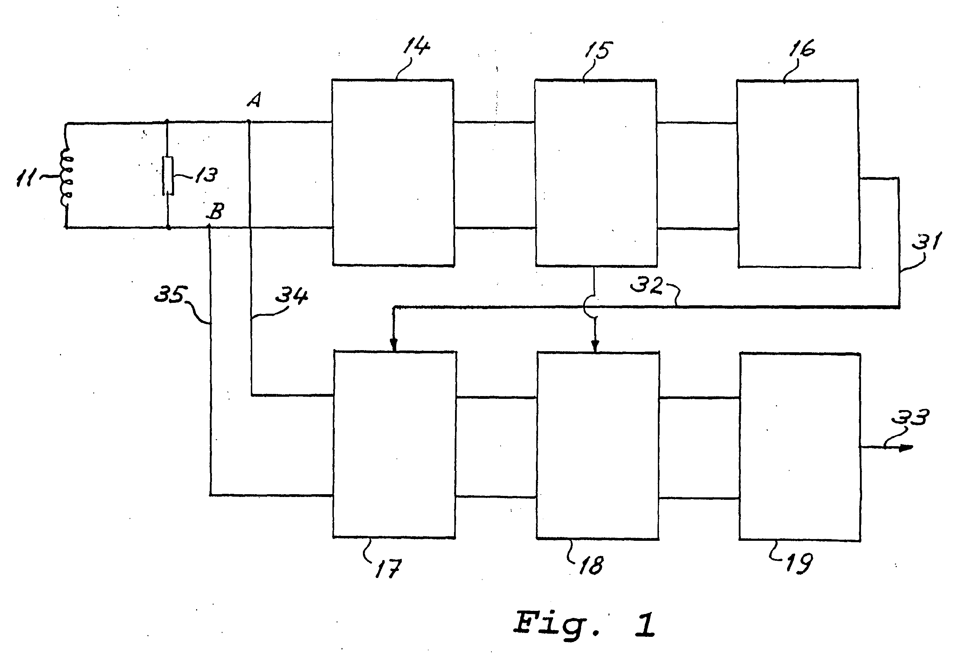

Wie in Fig. 1 schematisch dargestellt, enthält ein erfindungsgemässer Näherungsschalter eine Spule 11, die über eine gesteuerte Brückenschaltung 14 mit einem Impulsgenerator 15 verbunden ist. Ein Widerstand 13 ist parallel zur Spule geschaltet. Dieser Widerstand dient als Dämpfungswiderstand.

### Ausführungsbeispiel von Signalen, welche zum Betrieb der Schaltung gemäss Fig. 1 gehören

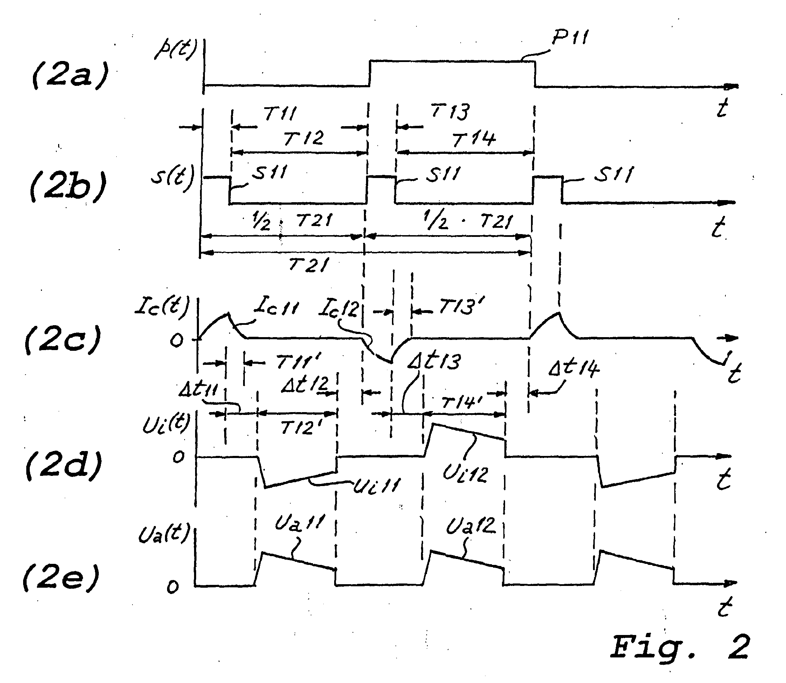

Die Diagramme 2a und 2b der Fig. 2 zeigen eine bevorzugte Ausführungsform der Steuersignale p(t) und s(t), mit welchen der Impulsgenerator 15 die Funktion der Brückenschaltung 14 steuert. Das Steuersignal p(t) steuert die Polarität der mit der Brückenschaltung 14 an die Spule 11 angelegte Gleichspannung. Das Steuersignal s(t) besteht aus periodischen Impulsen, die eine Dauer T11 bzw. T13 haben. Die Periode des Steuersignals p(t) ist T21.

Die Dauer von T21 beträgt z.B. 180 Mikrosekunden, diejenige von T11 und T13 20 Mikrosekunden.

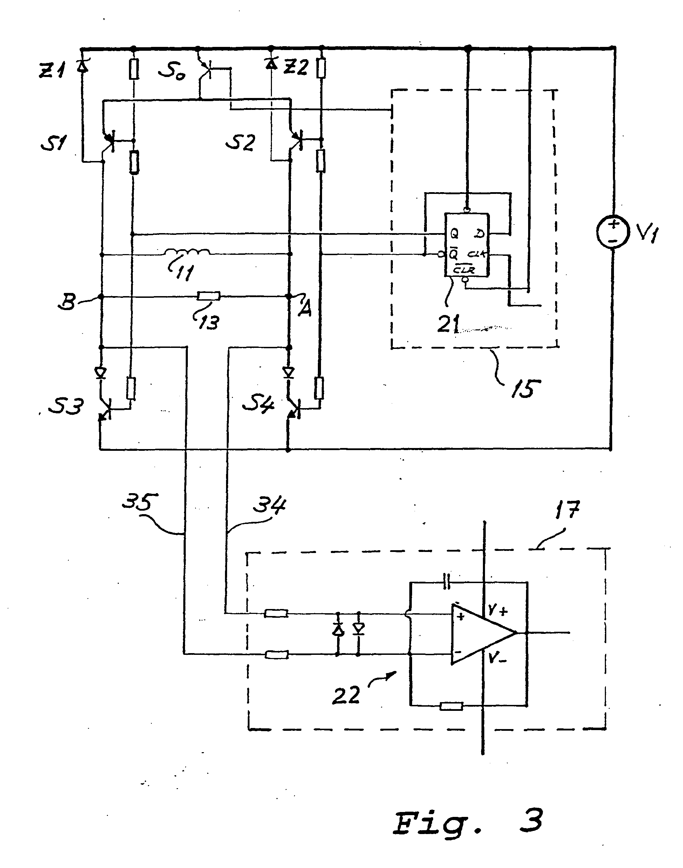

Die Steuerung der Brückenschaltung 14 während einer Periode T21 ist nachstehend anhand der Fig. 2 und 3 beschrieben. Durch ein vom Impulsgenerator 15 geliefertes Polaritätssignal P11 (Diagramm 2a) werden zu Beginn von T21 die Schalter S1 und S4 geschlossen, S2 und S3 geöffnet. Gleichzeitig wird durch einen Steuerimpuls S11 (Diagramm 2b) während eines Intervalls T11 der Schalter S0 geschlossen. Dadurch verbindet die Brückenschaltung 14 während dieses Intervalls T11 die Anschlüsse A, B in Fig. 3 mit den Anschlüssen einer Gleichspannungsquelle V1 derart, dass dadurch an die Spule 11 eine Gleichspannung +V1 angelegt wird.

Während des Intervalls T11 fliesst deshalb ein Strom Ic11 (Diagramm 2c) durch die Spule 11.

Am Ende von T11 wird durch das Signal S11 der Schalter S0 während des Intervalls T12 wieder geöffnet und damit die Spule 11 von der Spannungsquelle V1 getrennt. Der in der Spule 11 fliessende Strom Ic11 klingt während des Intervalls T11' über die Zenerdiode Z1 auf Null ab. Am Ende dieses Intervalls T11' und bis zum Ende des Intervalls T12 bleibt der Punkt A über S4 mit dem negativen Pol von V1 verbunden, während Punkt B weder über S1 noch über Z1 mit V1 verbunden und somit nur noch über die Verbindung 35 mit der hohen Eingangsimpedanz des Verstärkers 22 belastet ist.

In der Mitte von T21, d.h. nach der Zeit T11 + T12, werden durch das vom Impulsgenerator 15 gelieferte Polaritätssignal P11 (Diagramm 2a) die Schalter S2 und S3 geschlossen, S1 und S4 geöffnet. Gleichzeitig wird durch einen weiteren Steuerimpuls S11 (Diagramm 2b) während eines Intervalls T13 der Schalter S0 geschlossen. Dadurch verbindet die Brückenschaltung 14 während dieses Intervalls T13 die Anschlüsse A, B in Fig. 3 mit den Anschlüssen einer Gleichspannungsquelle V1 derart, dass dadurch an die Spule 11 eine Gleichspannung -V1 angelegt wird.

Während des Intervalls T13 fliesst deshalb ein Strom Ic12 (Diagramm 2c) durch die Spule 11.

Am Ende von T13 wird durch das Signal S11 der Schalter S0 während des Intervalls T14 wieder geöffnet und damit die Spule 11 von der Spannungsquelle V1 getrennt. Der in der Spule 11 fliessende Strom Ic12 klingt während des Intervalls T13' über die Zenerdiode Z2 auf Null ab. Am Ende dieses Intervalls T13' und bis zum Ende des Intervalls T14 bleibt der Punkt B über S3 mit dem negativen Pol von V1 verbunden, während Punkt A weder über S2 noch über Z2 mit V1 verbunden und somit nur noch über die Verbindung 34 mit der hohen Eingangsimpedanz des Verstärkers 22 belastet ist.

Durch Wiederholung des soeben beschriebenen Vorgangs wird die Spule 11 abwechselnd mit positiven und negativen Stromimpulsen beaufschlagt.

Wie soeben beschrieben, sind in einem erfindungsgemässen Näherungsschalter die Mittel zum Speisen der Spule 11 mit einem periodischen Sendestrom so eingerichtet, dass sie die Spule 11 mit periodischen Stromimpulsen beaufschlagen, deren Richtung periodisch wechselt, wobei:
- in der ersten Hälfte einer Periode T21 der durch die Speisemittel an die Spule abgegebene Sendestrom in einer ersten Richtung und im wesentlichen nur während eines ersten Intervalls der Dauer T11 fliesst, die kleiner als 1/2 * T21 ist, anschliessend während der Zeit T11' abklingt und während der Restzeit T12-T11' der ersten Hälfte der Periode T21 vernachlässigbar klein ist, und
- in der zweiten Hälfte der Periode T21 der durch die Speisemittel an die Spule abgegebene Sendestrom in einer der ersten entgegengesetzten Richtung und im wesentlichen nur während eines zweiten Intervalls der Dauer T13 fliesst, die kleiner als 1/2 * T21 ist, anschliessend während der Zeit T13' abklingt und während der Restzeit T14 der zweiten Hälfte der Periode T21 vernachlässigbar klein ist.

Die Intervalle T11 bzw. T13 sind vorzugsweise wesentlich kleiner als die Hälfte der Periode T21, wobei es vorteilhaft ist, T11 = T13 zu wählen, wie in Fig. 2b dargestellt.

Die Periode T21 des Steuersignals p(t) gemäss Diagramm 2a der Fig. 2 und der Sendestromimpulse gemäss Diagramm 2c umfasst die vier Intervalle T11, T12, T13, T14, wobei T21 = T11 + T12 + T13 + T14 ist.

Der oben beschriebene Stromverlauf in der Spule 11 erzeugt in der Umgebung der Spule 11 ein variables magnetisches Feld. Wie aus Fig. 5 ersichtlich, wird die Spule 11 so ausgerichtet, dass das genannte Feld durch die aktive Fläche 43 des Näherungsschalters austritt.

Wenn ein zu erfassender Körper sich im Einflussbereich dieses variablen magnetischen Feldes befindet, werden in diesem Körper ein Spannungen induziert. Diese Spannungen erzeugen durch magnetische Kopplung ihrerseits induzierte Spannungen Ui(t) in der Spule 11. Diese induzierten Spannungen sind im Diagramm 2d der Fig. 2 dargestellt. Die durch die Sendestromimpulse an der Spule 11 entstehenden Spannungen sind hier nicht dargestellt.

Die negative induzierte Spannung Ui11 wird von Strömen im erfassten Körper hervorgerufen, welche auf den positiven Sendestromimpuls Ic11 zurückzuführen sind, der während des Intervalls der Dauer T11 durch die Spule 11 fliesst.

Die positive induzierte Spannung Ui12 wird von Strömen im erfassten Körper hervorgerufen, welche auf den negativen Sendestromimpuls Ic12 zurückzuführen sind, der während des Intervalls der Dauer T13 durch die Spule 11 fliesst.

Wie aus Fig. 2 ersichtlich, ist mit der dort dargestellte Ausführungsform möglich, die periodischen Sendestromimpulsen so zu gestalten, dass jeder Sendestromimpuls, z.B. Ic12, zu einem Zeitpunkt beginnt, zu dem das Nutzsignal Ui11, welches vom vorhergehenden Sendestromimpuls Ic11 erzeugt wurde, erst zum Teil abgeklungen ist. Jeder Sendestromimpuls, z.B. Ic12, beginnt also bevor das vorhergehendes Nutzsignals Ui11 vollständig oder fast vollständig abgeklungen ist. Dies ermöglicht, die Taktfrequenz und damit die nutzbare Schaltfrequenz des Näherungsschalters erheblich zu erhöhen.

Wie nachstehend im Detail beschrieben, stehen die in der Spule 11 induzierten Spannungen Ui11, Ui12 etc., welche in den Baugruppen 17, 18 und 19 der Fig. 1 als Nutzsignal ausgewertet werden, zwischen den Anschlüssen A und B in Figur 1 und 3 an. Diesem Nutzsignal können Spannungen überlagert sein, die durch Streufelder in der Spule 11 induziert werden. Solche Störsignale sind in der Darstellung der induzierten Spannungen Ui11, Ui12, etc. im Diagramm 2d der Fig. 2 nicht gezeigt.

Die Anschlüsse A und B sind über die Leitungen 34 und 35 mit den Eingängen eines Eingangsverstärkers 17 verbunden. Diesem Verstärker ist ein Polaritätsschalter 18 nachgeschaltet, der, gesteuert durch das Steuersignal p(t), das an seinem Eingang anstehende Signal entweder invertiert oder nicht invertiert. Diesem Polaritätsschalter folgt ein Tiefpassfilter 19.

Die im Diagramm 2d der Fig. 2 dargestellten, in der Spule 11 induzierten Spannungen Ui11, Ui12, etc. werden dem Eingangsverstärker 17 zugeführt und dort wie folgt erfasst bzw. verarbeitet:

Während eines ersten Zeitfensters T12' wird die induzierte Spannung Ui11 vom Eingangsverstärker 17 als ein erstes Eingangssignal empfangen und dort verstärkt. Das Zeitfenster T12' beginnt nach dem Ende des Sendestromeimpulses Ic11 und liegt innerhalb der Restzeit der Dauer T12-T11' in der ersten Hälfte der Periode T.

Während eines zweiten Zeitfensters T14' wird die induzierte Spannung Ui12 vom Eingangsverstärker 17 als ein zweites Eingangssignal empfangen und dort verstärkt. Das Zeitfenster T14' beginnt nach dem Ende des Sendestromimpulses Ic12 und liegt innerhalb der Restzeit der Dauer T14-T13' in der zweiten Hälfte der Periode T.

Die zeitliche Lage und die Dauer des ersten Zeitfensters T12' und des zweiten Zeitfensters T14' werden von einer in Fig. 1 gezeigten Empfangsfenstersteuerung 16 über eine Leitung 31 gesteuert. Die Empfangsfenstersteuerung 16 wird ihrerseits von weiteren Steuersignalen gesteuert, die auch vom Impulsgenerator 15 geliefert werden.

In einer bevorzugten Ausführungsform beginnt das erste Zeitfenster T12' mit einer Verzögerung von Δt11 nach dem Beginn des Intervalls T12. Es endet gleichzeitig mit T12, so dass Δt12 = 0. Das zweite Zeitfenster T14' beginnt mit einer Verzögerung von Δt13 nach dem Beginn des Intervalls T14. Es endet gleichzeitig mit T14, so dass Δt14 = 0. Vorzugsweise haben das erste und das zweite Zeitfenster annähernd die gleiche Dauer T12' = T14'.

Der Verstärker 17 enthält Verstärkerstufen, welche sich dank des bipolaren Signalverlaufes mittels einer Wechselspannungskopplung koppeln lassen, was bei einem unipolaren Signalverlauf wegen des DC-Anteils nicht möglich ist. Die soeben erwähnte Wechselspannungskopplung hat den Vorteil, dass der Signalverstärker nicht schon infolge der Verstärkeroffsetspannung in Sättigung geht. Die erforderliche Verstärkung beträgt typisch 1000, die Verstärkeroffsetspannung typisch 10 mV, womit allein wegen der Verstärkeroffsetspannung bereits 10 V am Ausgang auftreten. Ohne Wechselspannungskopplung wäre der Verstärker daher bei einer typischen Betriebsspannung von 7 V bereits gesättigt. Bei Wechselspannungskopplung beträgt aber die DC-Verstärkung nur 1, d.h. die Offsetspannung ist nur noch 10 mV.

Die am Ausgang des Verstärkers 17 abgegebenen, verstärkten Signale Ui11, Ui12, etc. werden dem Eingang des Polaritätsschalters 18 zugeführt. Die Signale Ui11, Ui12 enthalten als zusätzliches Störsignal die Offsetspannung des Verstärkers 17.

Der Polaritätsschalter 18 wird von periodischen Steuerimpulsen der Periode T/2 umgeschaltet, um die Eingangssignale Ui11, Ui12, etc. während eines der entsprechenden Zeitfenster T12', T14' etc. zu invertieren bzw. nicht zu invertieren. Auf diese Weise wird mit dem Polaritätsschalter 18 aus der Impulsfolge Ui11, Ui12, etc. als Eingangssignal eine Impulsfolge als Ausgangssignal abgeleitet, die gemäss Diagramm 2e der Fig 2 aus einer Folge von Spannungsimpulsen Ua11, Ua12, etc. gleicher Polarität besteht.

Das Ausgangssignal des Polaritätsschalter 18 wird mittels eines Tiefpassfilters 19, das als Mittelwertbildner wirkt, geglättet, um ein Ausgangssignal zu erzeugen, welches das Vorhandensein eines zu erfassenden Körpers signalisiert. Durch die selektive Invertierung der negativen Nutzsignale, wie z.B. Ui11, durch den Polaritätsschalter 18 und die darauffolgende Mittelung und Glättung mittels des Tiefpassfilters 19 werden die durch Streufelder in der Spule 11 induzierte Störspannungen periodisch invertiert und durch die Mittelung und Glättung im Tiefpassfilter 19 weitgehend eliminiert. Am Ausgang des Tiefpassfilters erhält man daher ein Nutzsignal Ua(t) gemäss Diagramm 2e der Fig. 2 mit einem wesentlich verbesserten Störsignalabstand. Dies ermöglicht eine bedeutende Erhöhung des Schaltabstands des Näherungsschalters.

### Brückenschaltung 14

Figur 3 zeigt im Detail den Aufbau der Brückenschaltung 14 in Fig. 1 und Teile des Impulsgenerators 15 und des Eingangsverstärkers 17. Angesteuert durch Ausgangssignale des Impulsgenerators 15 und insbesondere durch Signale an den Ausgängen eines im Impulsgenerator 15 enthaltenen Flipflops 21 (in Fig. 3 ist vom Impulsgenerator 15 davon nur Flipflop 21 dargestellt) werden die Transistorengruppen S0, S2, S3 bzw. S0, S1, S4 abwechselnd in leitenden Zustand versetzt. Dadurch wird, wie oben bereits anhand der Figur 2 beschrieben, während den Intervallen T11 eine Gleichspannung +V1 und während den Intervallen T13 eine Gleichspannung -V1 an die Spule 11 gelegt.

Wie in Fig. 3 gezeigt, werden die in der Spule 11 induzierten Spannungen (gemäss Diagramm 2d der Fig. 2 bzw. Diagramm 2d der Fig. 2) über Leitungen 34, 35 einer Eingangsstufe 22 des Eingangsverstärkers 17 zugeführt (in Fig. 3 ist vom Eingangsverstärker 17 nur die Eingangsstufe 22 dargestellt).

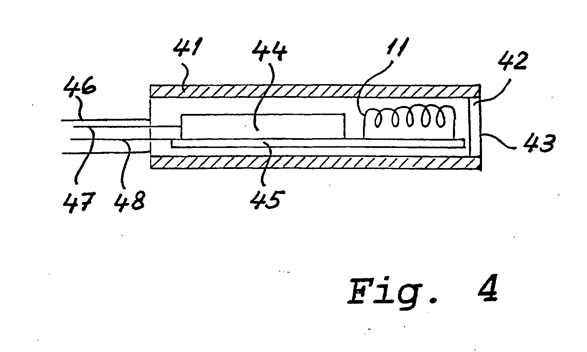

### Näherungsschalter gemäss Figur 4

Figur 4 zeigt einen schematischen Querschnitt eines Näherungsschalters, in dem eine Schaltung gemäss Fig. 1 enthalten ist. Wie aus Fig. 4 ersichtlich, sind alle Komponenten des Näherungsschalters in einem Gehäuse 21 angeordnet, welches in an sich bekannter Weise im wesentlichen aus einem metallischen Zylinder 41 und aus einer Kappe 42 aus einem Kunststoff besteht. Die Kappe schliesst das Ende des Zylinders 41 ab. Die Aussenfläche 43 der Kappe 42 bildet die aktive Fläche des Näherungsschalters 11, welche im Betrieb dem zu erfassenden Körper zugewandt ist.

In Figur 4 stellt der Block 44 alle in Figur 1 dargestellten Komponenten des Näherungsschalters mit Ausnahme der Spule 11 dar. Die Spule 11 und alle Komponenten des Blocks 44 sind beispielsweise auf eine gedruckte Leiterplatte 45 montiert. Der Block ist über Leitungen 47 und 48 eines Kabels 46 mit dem Gerät oder System (nicht gezeigt) verbunden, in dem die mit dem Näherungsschalter gewonnenen Signale weiterverarbeitet werden.

## Patentansprüche

1. Induktiver Näherungsschalter mit
- einer Spule,
- Mitteln zum Speisen der Spule mit periodischen Sendestromimpulsen, und
- Mitteln zum Verarbeiten von Signalen, die induzierten Spannungen entsprechen, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule induziert werden,
welcher Näherungsschalter
**dadurch gekennzeichnet ist, dass**
die Speisemittel dazu eingerichtet sind, der Spule (11) Sendestromimpulse zu liefern, deren Richtung periodisch wechselt, wobei jeweils
in der ersten Hälfte einer Periode (T21) der durch die Speisemittel an die Spule abgegebene Sendestrom in einer ersten Richtung und im wesentlichen nur während eines ersten Intervalls (T11) fliesst, dessen Dauer kleiner als die Hälfte der Periode (T21) der Sendestromimpulse ist, anschliessend während einem Zeitintervall (T11') abklingt und während der Restzeit (T12-T11') der ersten Hälfte der Periode (T21) vernachlässigbar klein ist, und
in der zweiten Hälfte der Periode (T21)der durch die Speisemittel an die Spule abgegebene Sendestrom in einer der ersten entgegengesetzten Richtung und im wesentlichen nur während eines zweiten Intervalls (T13) fliesst, das kleiner als die Hälfte der Periode (T21) der Sendestromimpulse ist, anschliessend während einem Zeitintervall (T13') abklingt und während der Restzeit (T14-T13') der zweiten Hälfte der Periode (T21)vernachlässigbar klein ist.

2. Induktiver Näherungsschalter gemäss Anspruch 1, **dadurch gekennzeichnet, dass** das erste bzw. das zweite Intervall (T11 bzw. T13) des Sendestromes eine Dauer haben, die wesentlich kleiner als die Hälfte der Periode (T21) der Sendestromimpulse ist.

3. Induktiver Näherungsschalter gemäss Anspruch 1 oder 2, **dadurch gekennzeichnet, dass** das erste und das zweite Intervall (T11, T13) des Sendestromes die gleiche Dauer haben.

4. Induktiver Näherungsschalter gemäss einem der vorangehenden Ansprüche, **dadurch gekennzeichnet, dass**
die Mittel zum Verarbeiten von Signalen dazu eingerichtet sind,
als ein erstes Eingangssignal und während eines ersten Zeitfensters (T12') eine erste in der Spule (11) induzierte Spannung (Ui1, Ui11) zu empfangen, die von Strömen im erfassten Körper hervorgerufen wird, welche auf den Sendestrom zurückzuführen ist, der durch die Spule während des ersten Intervalls (T11) fliesst, wobei das erste Zeitfenster (T12') nach der Unterbrechung dieses Sendestromes beginnt und innerhalb der genannten Restzeit (T12-T11') der ersten Hälfte der Periode (T21) der Sendestromimpulse liegt,
und
als ein zweites Eingangssignal und während eines zweiten Zeitfensters (T14') eine zweite in der Spule (11) induzierte Spannung (Ui12) zu empfangen, die von Strömen im erfassten Körper hervorgerufen wird, welche auf den Sendestrom zurückzuführen ist, der durch die Spule während des zweiten Intervalls (T13) fliesst, wobei das zweite Zeitfenster nach der Unterbrechung dieses Sendestromes beginnt und innerhalb der genannten Restzeit (T14, T13') der zweiten Hälfte der Periode (T21) der Sendestromimpulse liegt.

5. Induktiver Näherungsschalter gemäss Anspruch 4, **dadurch gekennzeichnet, dass** sowohl das erste Zeitfenster (T12') als auch das zweite Zeitfenster (T14') sich bis an das Ende einer Hälfte einer Periode (T21) erstrecken.

6. Induktiver Näherungsschalter gemäss Anspruch 4 oder 5, **dadurch gekennzeichnet, dass** das erste und das zweite Zeitfenster (T12', T14') die gleiche oder annähernd die gleiche Dauer haben.

7. Induktiver Näherungsschalter gemäss einem der Ansprüche 1 bis 6, **dadurch gekennzeichnet, dass** die Mittel zum Verarbeiten von Signalen einen Polaritätsschalter (18) enthalten, der von periodischen Impulsen umgeschaltet wird, deren Periode die Hälfte der Periode (T21) der Sendestromimpulse beträgt, um das erste oder das zweite Eingangssignal während des ersten bzw. zweiten Zeitfensters zu invertieren bzw. um es nicht zu invertieren, so dass die Eingangssignale abwechselnd invertiert bzw. nicht invertiert werden, um ein Ausgangssignal (Ua11) zu erzeugen, dass aus einer Folge von Spannungsimpulsen gleicher Polarität besteht.

8. Induktiver Näherungsschalter gemäss Anspruch 7, **dadurch gekennzeichnet, dass** das Ausgangssignal des Polaritätsschalters mittels eines Tiefpassfilters gemittelt und geglättet wird, um ein Ausgangssignal zu erzeugen, welches das Vorhandensein eines zu erfassenden Körpers signalisiert.

9. Induktiver Näherungsschalter gemäss einem der vorangehenden Ansprüchen 1 bis 8, **dadurch gekennzeichnet, dass** jeder Sendestromimpuls (Ic12) zu einem Zeitpunkt beginnt, zu dem das Nutzsignal (Ui11), welches vom vorhergehenden Sendestromimpuls (Ic11) erzeugt wurde, erst zum Teil abgeklungen ist.

## Claims

1. Inductive proximity switch comprising:
- a coil,
- means for supplying the coil with periodic transmitting current pulses, and
- means for processing signals that correspond to voltages induced in the coil after the end of a transmitting current pulse by the decaying current previously flowing in the body that is to be detected due to the voltage induced therein by the transmitting current pulse,
which proximity switch
is **characterised in that**
the supply means are adapted to supply the coil (11) with transmitting current pulses whose direction alternates periodically, while
in the first half of each period (T21), the transmitting current delivered to the coil by the supply means flows in a first direction and essentially only during a first interval (T11) whose duration is shorter than half of the period (T21) of the transmitting current pulses, subsequently decays during a time interval (T11'), and is negligibly small during the remaining time (T12-T11') of the first half of the period (T21), and
in the second half of the period (T21), the transmitting current delivered to the coil by the supply means flows in a direction opposite to the first one and essentially only during a second interval (T13) that is shorter than half of the period (T21) of the transmitting current pulses, subsequently decays during a time interval (T13'), and is negligibly small during the remaining time (T14-T13') of the second half of the period (T21).

2. Inductive proximity switch according to claim 1, **characterised in that** the first and the second interval of the transmitting current have respective durations (T11 respectively T13) that are substantially shorter than half the period (T21) of the transmitting current pulses.

3. Inductive proximity switch according to claim 1 or 2, **characterised in that** the first and the second interval (T11, T13) of the transmitting current have the same duration.

4. Inductive proximity switch according to one of the preceding claims, **characterised in that**
the signal processing means are adapted
to receive, as a first input signal and during a first time window (T12'), a first voltage (Ui1, Ui11) induced in the coil (11) that is generated by currents in the detected body which originate from the transmitting current flowing in the coil during the first interval (T11), the first time window (T12') beginning after the interruption of this transmitting current and lying within the mentioned remaining time (T12-T11') of the first half of the period (T21) of the transmitting current pulses,
and
to receive, as a second input signal and during a second time window (T14'), a second voltage (Ui12) induced in the coil (11) that is generated by currents in the detected body which originate from the transmitting current flowing in the coil during the second interval (T13), the second time window beginning after the interruption of this transmitting current and lying within the mentioned remaining time (T14, T13') of the second half of the period (T21) of the transmitting current pulses.

5. Inductive proximity switch according to claim 4, **characterised in that** both the first time window (T12') and the second time window (T14') extend up to the end of one half of a period (T21).

6. Inductive proximity switch according to claim 4 or 5, **characterised in that** the first and the second time window (T12', T14') have the same or approximately the same duration.

7. Inductive proximity switch according to one of claims 1 to 6, **characterised in that** the signal processing means include a polarity switch (18) that is switched by periodical pulses whose period is equal to half of the period (T21) of the transmitting current pulses in order to invert respectively not to invert the first or the second input signal during the first respectively the second time window so that the input signals are alternatingly inverted respectively not inverted in order to generate an output signal (Ua11) that consists of a succession of voltage pulses of the same polarity.

8. Inductive proximity switch according to claim 7, **characterised in that** the output signal of the polarity switch is averaged and smoothened by means of a low-pass filter in order to generate an output signal that signals the presence of a body that is to be detected.

9. Inductive proximity switch according to one of preceding claims 1 to 8, **characterised in that** each transmitting current pulse (Ic12) begins at a point of time when the wanted signal (Ui11) generated by the previous transmitting current pulse (Ic11) has only partially decayed.

## Revendications

1. Commutateur de proximité inductif comprenant
- une bobine,
- des moyens pour alimenter à la bobine des impulsions de courant d'émission périodiques, et
- des moyens pour le traitement de signaux qui correspondent à des tensions induites après la fin d'une impulsion de courant d'émission dans la bobine par le courant décroissant qui circule dans le corps à détecter en raison de la tension induite dans celui-ci par l'impulsion de courant d'émission,
lequel commutateur de proximité
est **caractérisé en ce que**
les moyens d'alimentation sont agencés de manière à délivrer à la bobine (11) des impulsions de courant d'émission dont la direction change périodiquement alors que
pendant la première moitié d'une période (T21), le courant d'émission alimenté à la bobine par les moyens d'alimentation circule dans une première direction et essentiellement pendant un premier intervalle (T11) uniquement dont la durée est inférieure à la moitié de la période (T21) des impulsions de courant d'émission, décroît ensuite pendant un intervalle de temps (T11') et est négligeable pendant le temps restant (T12-T11') de la première moitié de la période (T21), et
pendant la deuxième moitié de la période (T21), le courant d'émission alimenté à la bobine par les moyens d'alimentation circule dans une direction opposée à la première et essentiellement pendant un deuxième intervalle (T13) uniquement qui est plus court que la moitié de la période (T21) des impulsions de courant d'émission, décroît ensuite pendant un intervalle de temps (T13') et est négligeable pendant le temps restant (T14-T13') de la deuxième moitié de la période (T21).

2. Commutateur de proximité inductif selon la revendication 1, **caractérisé en ce que** le premier respectivement le deuxième intervalle (T11 respectivement T13) du courant d'émission ont une durée qui est substantiellement inférieure à la durée de la période (T21) des impulsions de courant d'émission.

3. Commutateur de proximité inductif selon la revendication 1 ou 2, **caractérisé en ce que** le premier et le deuxième intervalle (T11, T13) du courant d'émission ont la même durée.

4. Commutateur de proximité inductif selon l'une des revendications précédentes, **caractérisé en ce que**
les moyens pour le traitement de signaux sont adaptés à
recevoir comme un premier signal d'entrée et pendant une première fenêtre de temps (T12') une première tension (Ui1, Ui11) induite dans la bobine (11) laquelle est générée par des courants dans le corps détecté qui sont engendrés par le courant d'émission circulant dans la bobine pendant le premier intervalle (T11), ladite première fenêtre de temps (T12') commençant après l'interruption de ce courant d'émission et étant située à l'intérieur dudit temps restant (T12-T11') de la première moitié de la période (T21) des impulsions de courant d'émission,
et
à recevoir comme un deuxième signal d'entrée et pendant une deuxième fenêtre de temps (T14') une deuxième tension (Ui12) induite dans la bobine (11) laquelle est générée par des courants dans le corps détecté qui sont engendrés par le courant d'émission circulant dans la bobine pendant le deuxième intervalle (T13), ladite deuxième fenêtre de temps commençant après l'interruption de ce courant d'émission et étant située à l'intérieur dudit temps restant (T14, T13') de la deuxième moitié de la période (T21) des impulsions de courant d'émission.

5. Commutateur de proximité inductif selon la revendication 4, **caractérisé en ce que** tant la première fenêtre de temps (T12') que la deuxième fenêtre de temps (T14') s'étendent jusqu'à la fin d'une moitié d'une période (T21).

6. Commutateur de proximité inductif selon la revendication 4 ou 5, **caractérisé en ce que** la première et la deuxième fenêtre de temps (T12', T14') ont la même ou approximativement la même durée.

7. Commutateur de proximité inductif selon l'une des revendications 1 à 6, **caractérisé en ce que** les moyens pour le traitement de signaux comprennent un commutateur de polarité (18) qui est commuté par des impulsions périodiques dont la période est égale à la moitié de la période (T21) des impulsions de courant d'émission afin d'inverser respectivement ne pas inverser le premier ou le deuxième signal d'entrée pendant la première respectivement la deuxième fenêtre de temps, de sorte que les signaux d'entrée sont alternativement inversés respectivement ne pas inversés afin de générer un signal de sortie (Ua11) composé d'une succession d'impulsions de tension ayant la même polarité.

8. Commutateur de proximité inductif selon la revendication 7, **caractérisé en ce que** le signal de sortie du commutateur de polarité est moyennée et lissée au moyen d'un filtre passe-bas afin de générer un signal de sortie qui signale la présence d'un corps à détecter.

9. Commutateur de proximité inductif selon l'une des revendications précédentes 1 à 8, **caractérisé en ce que** chaque impulsion (Ic12) de courant d'émission commence à un instant où le signal utile (Ui11) généré par l'impulsion de courant d'émission précédent (Ic11) ne n'a décru que partiellement.
